# EUROPEAN PATENT APPLICATION

(11) **EP 2 447 393 A1**
(43) Date of publication of application: **02.05.2012**
(21) Application number: 10189131.5
(22) Date of filing: 27.10.2010
(51) Int. Cl.: C23C 14/22, C23C 14/54, C23C 14/56

(54) **Evaporation system and method**

(71) Applicant: Applied Materials, Inc., Santa Clara, CA 95054 (US)
(72) Inventor: Maurer, Philipp, 63820, Elsenfeld (DE); Schramm, Sven, 63796, Kahl am Main (DE); Lopp, Andreas, 63579, Freigericht (DE); Klöppel, Andreas, 63695, Glauburg (DE)
(74) Representative: Zimmermann & Partner

(57) **Abstract**

A deposition system is provided which is adapted for depositing a thin film onto a substrate. The deposition system includes a substrate carrier adapted for carrying the substrate and at least one tilted evaporator crucible. The at least one tilted evaporator crucible is adapted for directing evaporated deposition material towards the substrate in a main emission direction. The main direction emission of the tilted evaporator crucible is different from a direction normal to the substrate.

## Description

### TECHNICAL FIELD OF THE INVENTION

Embodiments of the present invention generally relate to thin-film deposition systems and evaporation devices used in systems for forming thin-films. In particular, the present invention relates to an evaporator device having evaporator crucibles for evaporation of deposition material to be deposited onto substrates. In addition to that, the present invention relates to a method for depositing a thin film onto a substrate using an evaporation system.

### BACKGROUND OF THE INVENTION

Devices for an efficient conversion of solar energy into electrical energy are of increasing importance. Such energy conversion devices may be based on thin-film solar cells which can be produced by depositing appropriate thin films onto substrates such as wafers. It is a current trend to provide large area solar cells formed on large substrates. These substrates may be transported through a deposition apparatus being adapted for applying different thin films onto the substrates.

Evaporator devices may be used for evaporating deposition material for forming thin films onto the substrates. Specifically, e.g. for large area solar cells, a good layer uniformity with respect to composition and layer thickness is desired. Additionally, manufacturing costs for manufacturing thin-film devices need to be decreased and deposition material needs to be utilized in an effective manner.

### SUMMARY OF THE INVENTION

In light of the above, a deposition system adapted for depositing a thin film onto a substrate in accordance with independent claim 1 and a method for depositing a thin film onto a substrate in accordance with independent claim 12 are provided.

According to one embodiment, a deposition system adapted for depositing a thin film onto a substrate is provided, the deposition system including a substrate carrier adapted for carrying the substrate; and at least one tilted evaporator crucible adapted for directing evaporated deposition material towards the substrate in a main emission direction, wherein the main emission direction of the tilted evaporator crucible is different from a direction normal to the substrate.

According to a further embodiment, a method for depositing a thin film onto a substrate is provided, the method including providing at least one evaporator crucible, providing a substrate carrier in the vicinity of the at least one evaporator crucible, loading the substrate onto the substrate carrier, and evaporating deposition material from the at least one evaporator crucible towards the substrate in a main emission direction different from a direction normal to the substrate.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: shows an evaporator crucible evaporating deposition material in a vapor cone, in a schematic view for explaining the principles of the evaporation technique;
- Figure 2: is a schematic sectional view of a deposition system adapted for depositing a thin film onto a substrate, wherein one evaporator crucible supported in a support unit is illustrated, according to a typical embodiment;
- Figure 3: is a graph illustrating a film thickness profile across a width of a substrate to be coated;
- Figure 4: is another graph showing another film thickness profile for illustrating the principle of a typical embodiment;
- Figure 5: is yet another graph showing yet another film thickness profile;
- Figure 6: is yet another graph indicating three different film thickness profiles for the comparison of different evaporator arrangements of a deposition system according to another typical embodiment;
- Figure 7: is a sectional view of a deposition system having a number of evaporator crucibles tilted with respect to a surface normal of the substrate to be coated;
- Figure 8: is a thickness distribution graph showing four different thickness profiles for comparison of different evaporator crucible arrangements provided in a deposition device shown in Fig. 7, according to a typical embodiment;
- Figure 9: is a sectional view of a deposition system having a number of evaporator crucibles, according to another typical embodiment; and
- Figure 10: is a flow chart illustrating a method for depositing a thin film onto a substrate, according to a typical embodiment.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a deposition system adapted for depositing a thin film onto a substrate, wherein depositing deposition material onto a substrate surface typically is based on evaporating the deposition material. The deposition system includes an evaporator device having a number of evaporator crucibles. The evaporator crucibles may be arranged such that a good layer uniformity of a layer deposited onto the substrate surface may be achieved.

Solar cells may be manufactured using large area substrates. These substrates may be transported through the deposition system in a substrate transport direction. The substrates may be transported by means of a substrate carrier which is adapted to hold the substrate during transportation and during the deposition process. The substrates may be provided as individual wafers which are held by means of appropriate substrate carriers. Moreover, the substrate may be provided as a flexible web that is guided through a deposition region of the deposition system. For example, the web may be a foil which is transported through the deposition system in the substrate transport direction.

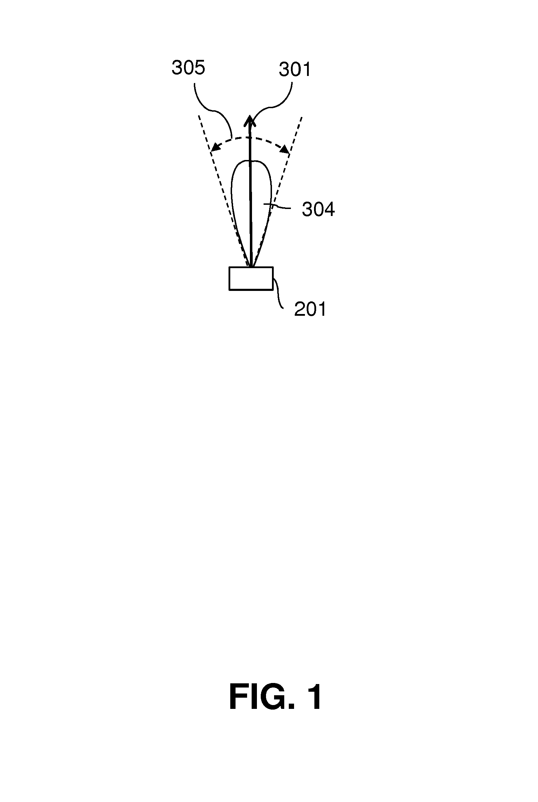

According to embodiments described herein, a thin-film deposition system may include a number of evaporator crucibles 201 as shown in Fig. 1. The evaporator crucible 201 is adapted for evaporating deposition material in a main emission direction 301. The deposition material is directed towards a substrate to be coated (not shown in Fig. 1), wherein a vapor cone 304 is emitted from the evaporator crucible 201 in the main emission direction 301. According to the vapor cone 304 provided by the evaporator crucible 201, an aperture angle 305 may be defined within which material to be deposited onto the substrate is emitted from the evaporator crucible 201.

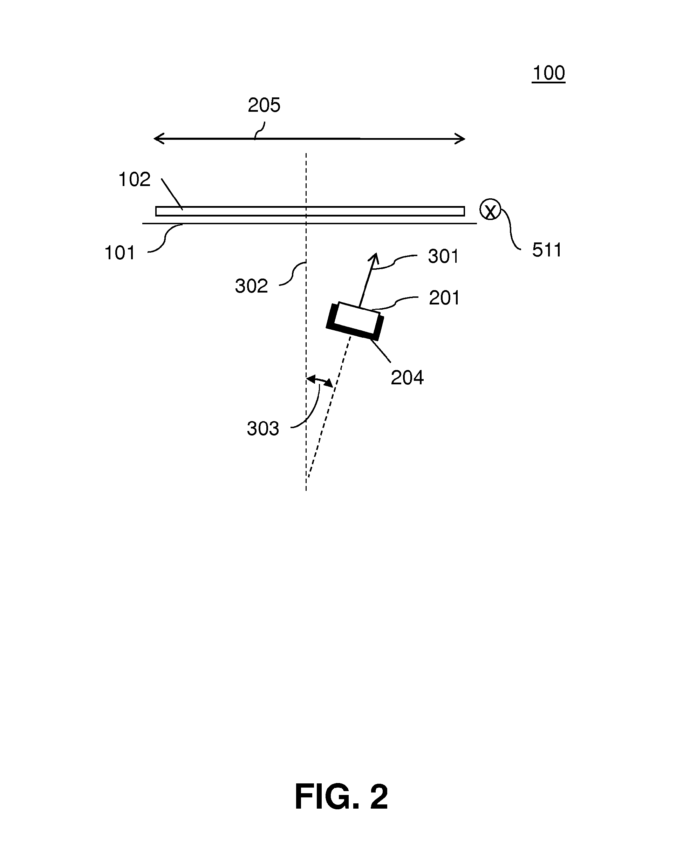

Fig. 2 is a sectional view of a deposition system 100 according to a typical embodiment. A substrate 101 to be coated by thin film material evaporated by an evaporator device 200 is held at a substrate carrier 102. The evaporator device 200 may include a number of evaporator crucibles 201, however, only one evaporator crucible 201 is shown in Fig. 2. The evaporator crucible 201 is held by a tiltable or tilted support unit 204, the tiltable or tilted support unit 204 being adapted for individually adjusting the main emission direction 301 of the evaporator crucible 201.

It is thus possible to provide a tilt angle 303 between a surface normal 302 of the substrate to be coated and the main emission direction 301. As can be seen from the schematic setup shown in Fig. 2, the main emission direction 301 of the evaporator crucible 201 has an influence on where the deposition material evaporated by the evaporator crucible 201 is deposited onto the substrate 101.

As will be shown herein below, a number of evaporator crucibles 201 may be arranged, typically in a line, each evaporator crucible 201 providing an individual main emission direction 301. Thus, layer uniformity may be influenced by an appropriate adjustment of the individual main emission directions 301 of the respective evaporator crucibles 201. Furthermore, the vapor cone 304 (see Fig. 1) of an individual evaporator crucible 201 may be adjusted. Typically, evaporating deposition material from the evaporator crucible 201 may include spacially varying the vapor cone 304 of the evaporator crucible 201.

According to a typical embodiment, the main emission direction 301 may be tilted by a tilt angle 303 in a range from -60° to +60°, typically in a range from -25° to +25°, more typically in a range from -15° to +15°, and even more typically in a range from -5° to +5°, with respect to the surface normal 302 of the substrate 101. Furthermore, according to yet another typical embodiment, the vapor cone 304 may be adjusted prior to a deposition process.

The evaporator crucible may provide a vapor cone 304 having a cosine exponent in a range from 1 to 5. Typically, the vapor cone 304 is extended approximately symmetrically with respect to the main emission direction 301 of the evaporator crucible 201.

It is noted here that the evaporator crucible 201 may be tilted in both directions with respect to the surface normal 302 of the substrate 101, i.e. in addition to a clockwise tilt shown in Fig. 2, a counter-clockwise tilt, i.e. to the left side of the surface normal 302 shown in Fig. 2, may be provided. For the further understanding of typical embodiments described herein, a positive tilt angle 303 is defined as a tilt angle providing a tilt of the evaporator crucible 201 in a clockwise direction in the drawings, i.e. in a direction shown in Fig. 2, whereas a counter-clockwise tilt in the drawings is indicated by a negative tilt angle 303.

By tilting the tiltable support unit 204 with respect to the surface normal 302, an individual deposition direction, i.e. a main emission direction 301 of an evaporator crucible 201 may be provided. It is noted here that the expression "normal to the substrate" indicates a direction of the surface normal 302 defined at a right angle with respect to the surface of the substrate 101.

The substrate 101 may be transported in a direction which is perpendicular to the plane of drawing of Fig. 2. Thus, by tilting the evaporator crucible 201, deposition material may be directed along a width 205 of the substrate 101, the width coordinate being defined in a direction perpendicular to the substrate transport direction 511 along one side of the substrate 101. The evaporator device 200 may have a width of 300 mm or more, the width being typically in a range from approximately 500 mm to 4500 mm.

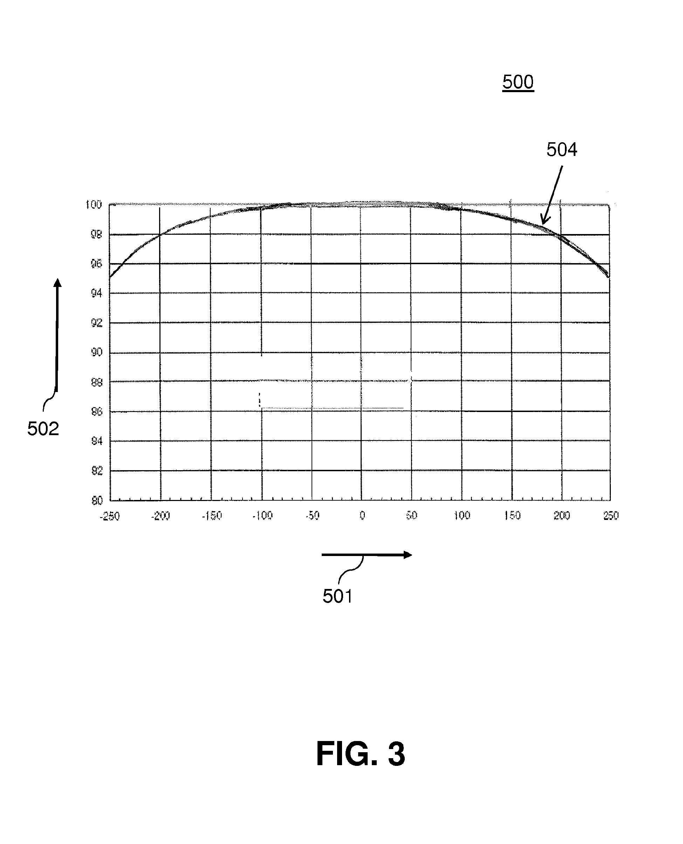

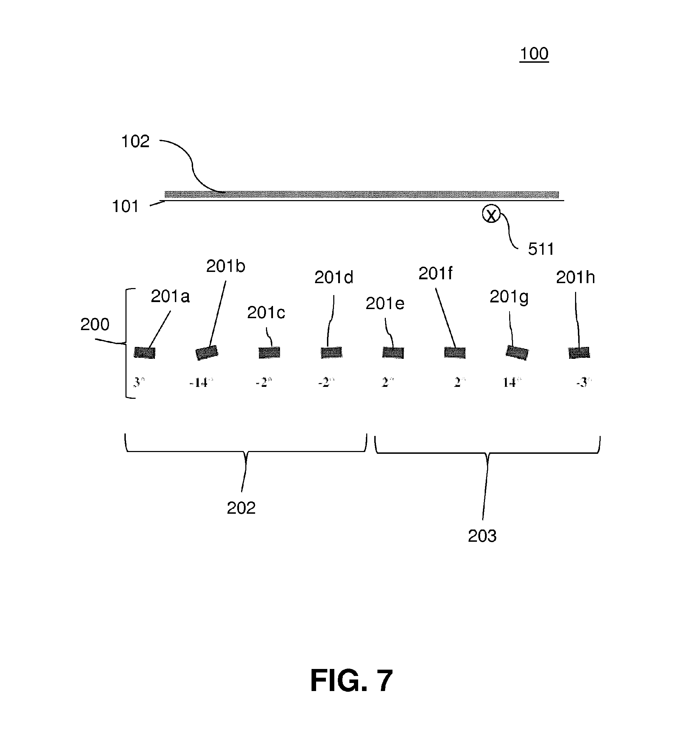

Fig. 3, Fig. 4 and Fig. 5 are thickness distribution graphs 500 for explaining the principle of depositing thin films by an evaporator device 200. The thickness distribution graphs 500 exhibit a deposition rate 502 as a function of a substrate width coordinate 501. The deposition rate is given an arbitrary units (a.u.), wherein the substrate width coordinate is given in millimeters (mm). Thus, the diagrams of Fig. 3, 4 and 5 are related to a substrate having a width of 0.5 meters. Along the width coordinate of the substrate 101 individual evaporator crucibles 201 (shown herein below with respect to Fig. 7) are arranged. In a setup providing a deposition rate shown in Figs. 3, 4 and 5, evaporator crucibles are arranged at specific crucible positions, the crucible positions having a spacing of 80 mm with respect to each other.

It is noted here that a plurality of evaporator crucibles 201 may be arranged at a fixed distance with respect to each other, i.e. at a pitch in a range from 20 mm to 100 mm, and typically the evaporator crucibles 201 are arranged at a pitch of approximately 80 mm with respect to one another. Alternatively, the evaporator crucibles 201 may be arranged at variable distances with respect to one another, i.e. the distance between two adjacent evaporator crucibles 201 may be different from another distance between two other adjacent evaporator crucibles 201.

According to the graphs shown in Fig. 3, 4 and 5, evaporator crucibles 201 are arranged at a substrate width coordinate of ± 40 mm, ± 120 mm, ± 200 mm and ± 280 mm, wherein the outermost positions of the evaporator crucibles are not shown in Figs. 3, 4 and 5. In the following, specific evaporation processes using evaporator devices 200 will be described with respect to Figs. 3, 4 and 5. It is noted here that the deposition rate distribution shown in Figs. 3, 4 and 5 corresponds to a film thickness profile 504, i.e. a higher deposition rate 502 results in a larger film thickness and vice versa. According to a typical embodiment which can be combined with other embodiments described herein, the substrate width 205 may assume any appropriate value suited for a desired deposition process, wherein evaporator crucibles 201 may be arranged at relative positions with respect to a full width 205 of the substrate 101, for example at positions corresponding to approximately 0%, 20%, 40%, 60%, 80% and 100% of the full width 205 of the substrate 101. According to yet an alternative embodiment, a plurality of evaporator crucibles 201 may be arranged at a fixed distance with respect to each other, i.e. at a pitch in a range from 5% to 50% of the full width 205 of the substrate 101, typically at a pitch in a range from 10% to 25% of the full width 205, and more typically at a pitch of approximately 20 % of the full width 205.

The deposition system 100 in accordance with a typical embodiment is arranged such that a distance between the substrate carrier 102 and the evaporation device 200 is in a range from 50 mm to 400 mm, and typically amounts to approximately 200 mm. Furthermore, the at least one evaporation crucible 201 is adapted for providing a vapor cone having a cosine exponent in a range from 1 to 5. According to another typical embodiment which can be combined with other embodiments described herein, the vapor cone may range from 3 to 4, and more typically may have a value of approximately 3.5. Moreover, evaporating deposition material from the at least one evaporator crucible 201 may include varying a vapour cone of the at least one evaporator crucible 201.

For obtaining the film thickness profiles shown in Figs. 3, 4 and 5, it is assumed that the distance between the evaporator crucible 201 and the surface of the substrate 101 to be coated amounts to approximately 200 mm, and the cosine exponent of the vapor cone 304 (see Fig. 1) amounts to approximately 3.5.

Fig. 3 shows a film thickness profile 504 which is obtained in a deposition process based on an evaporator device having ten individual evaporator crucibles 201 arranged at a pitch of 80 mm along the substrate width coordinate 501. The layer thickness inhomogenity is approximately ± 2.5%.

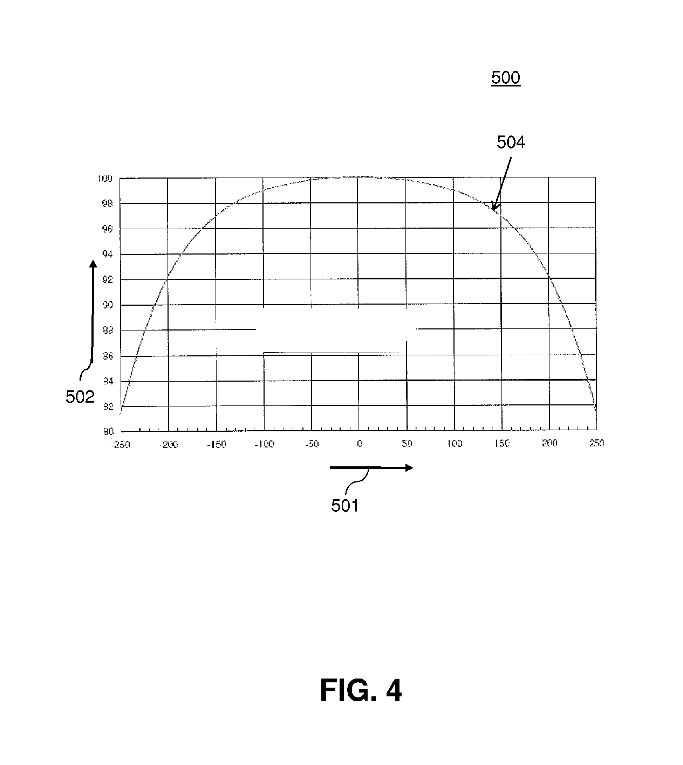

Fig. 4 exhibits another film thickness profile 504 wherein the two outermost evaporator crucibles have been removed such that a material evaporation is provided by only eight evaporator crucibles 201. The resulting layer thickness inhomogenity increases with respect to the situation shown in Fig. 3, up to a layer thickness inhomogenity of typically 10% and a large thickness gradient at the edges (± 250 mm) of the substrate 101.

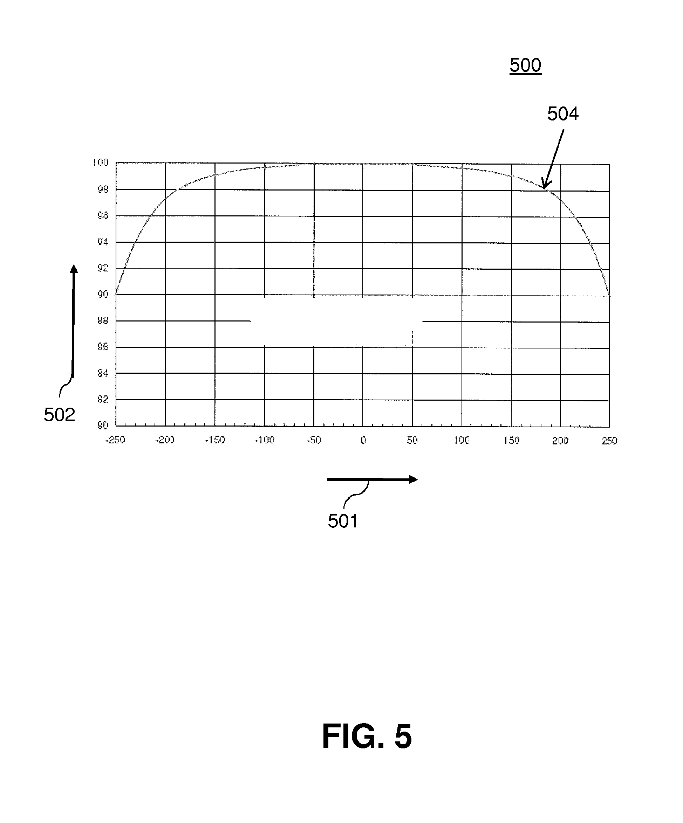

According to a typical embodiment which can be combined with other embodiments described herein, the evaporation rate of the outermost evaporator crucibles is larger than the evaporation rate of inner evaporator crucibles by an amount in a range from 5 % to 50 %, typically in a range from 10 % to 30 %, and more typically by an amount of approximately 25 %. Fig. 5 is a thickness distribution graph 500 showing a film thickness profile 504 which has been obtained by increasing an evaporation rate of the two outermost evaporator crucibles 201 by approximately 25%. It is thus possible to obtain a thickness homogenity of ± 5% using eight individual evaporator crucibles 201. As shown in Fig. 5, a decrease of the film thickness at the left and right edges of the substrate 101 is present.

It is noted here that, in order to explain the principles of typical embodiments, the deposition system 100 adapted for obtaining film thickness profiles 504 shown in Figs. 3, 4 and 5, respectively, only includes evaporator crucibles 201 which have a tilt angle 303 of zero degrees (0°), i.e. the main emission directions 301 of the individual evaporator crucibles 201 coincide with the surface normal 302 (not shown in Figs. 3, 4 and 5).

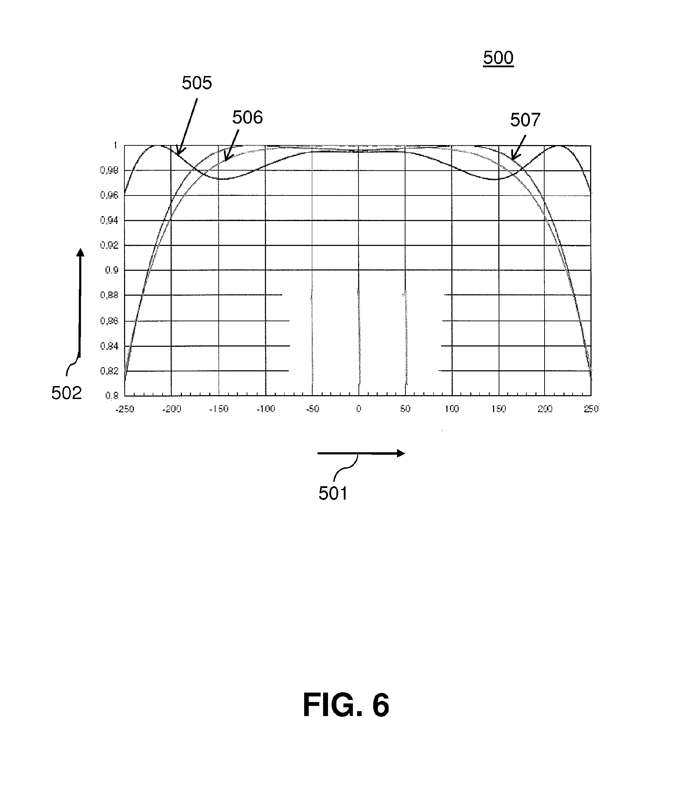

Fig. 6 and Fig. 7 relate to another typical embodiment, which can be combined with other embodiments described herein. Here, individual evaporator crucibles 201 are tilted by a respective tilt angle 303, wherein the individual tilt angles 303 for obtaining the film thickness profiles across the substrate width are summarized in table 1 herein below. In Fig. 6, three different film thickness profiles are indicated, i.e. a first film thickness profile 505 obtained by an arrangement of evaporator crucibles 201a-201h of an evaporator device 200 shown in Fig. 7, a second film thickness profile 506 obtained in accordance with a different arrangement of tilt angles 303 of the evaporator crucibles 201 and a third film thickness profile 507 obtained by still another arrangement of the evaporator crucibles 201. Again, as in the situation shown in Figs. 4 and 5, eight individual evaporator crucibles 201a-201h are provided, the spacing of the individual evaporator crucibles 201 being approximately 80 mm.

As shown in Fig. 7, the evaporator crucibles 201a-201h are divided into two groups of evaporator crucibles 201, i.e. the first group 202 of evaporator crucibles 201a-201d, and a second group 203 of evaporator crucibles 201e-201h. A tilt angle of the individual evaporator crucibles 201 is indicated by the numbers (given in degrees; °) corresponding to the individual evaporator crucibles 201. As shown in Fig. 7, the evaporator crucibles 201a, 201b, 201c and 201d of the first group 202 and the evaporator crucibles 201e, 201f, 201g and 201h of the second group 203 of evaporator crucibles 201 are arranged symmetrically to a plane which is perpendicular to the substrate 101 and parallel to the substrate transport direction 511 and the surface normal 302 (see Fig. 2).

As indicated herein above, a positive angle represents a tilt in the clockwise direction in Fig. 7, whereas a negative angle represents a tilt in the counter-clockwise direction in Fig. 7. The arrangement of the eight evaporator crucibles 201a-201h shown in Fig. 7 results in the first film thickness profile 505 shown in Fig. 6. As compared to the film thickness profiles shown in Figs. 3, 4 and 5, the first film thickness profile 505 shown in Fig. 6 indicates an increased layer homogeneity. An inhomogeneity of the layer thickness has been decreased to approximately ± 2% by the action of an individual tilt of the eight evaporator crucibles 201a-201h.

The second film thickness profile 506 shown in Fig. 6 and the third film thickness profile 507 shown in Fig. 6 have been obtained for comparison purposes. The second film thickness profile 506 corresponds to a tilt of the outermost evaporator crucibles 201a and 201h towards the edges of the substrate 101 by an angle of 5°, whereas the third film thickness profile 507 has been obtained by tilting the outermost evaporator crucibles 201a, 201h at an angle of approximately 10°.

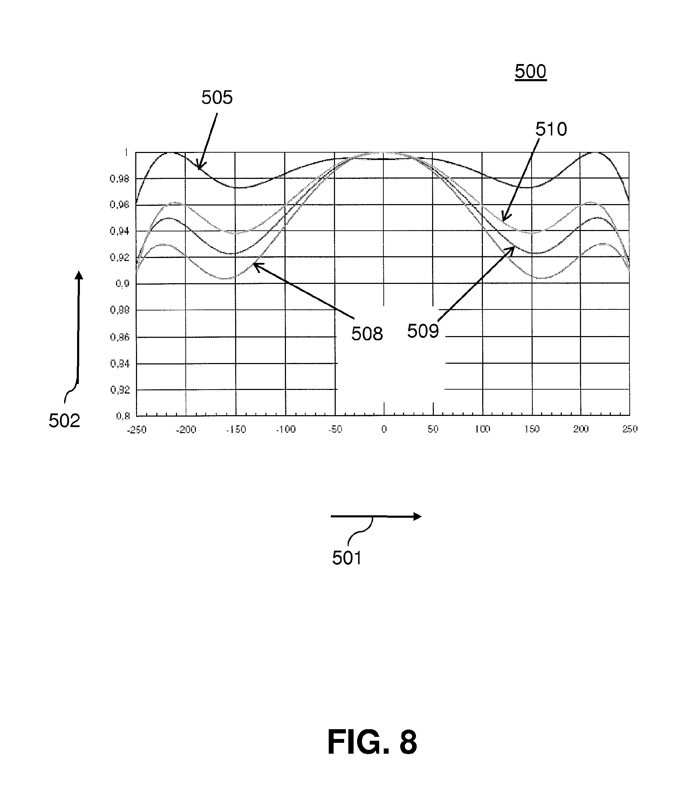

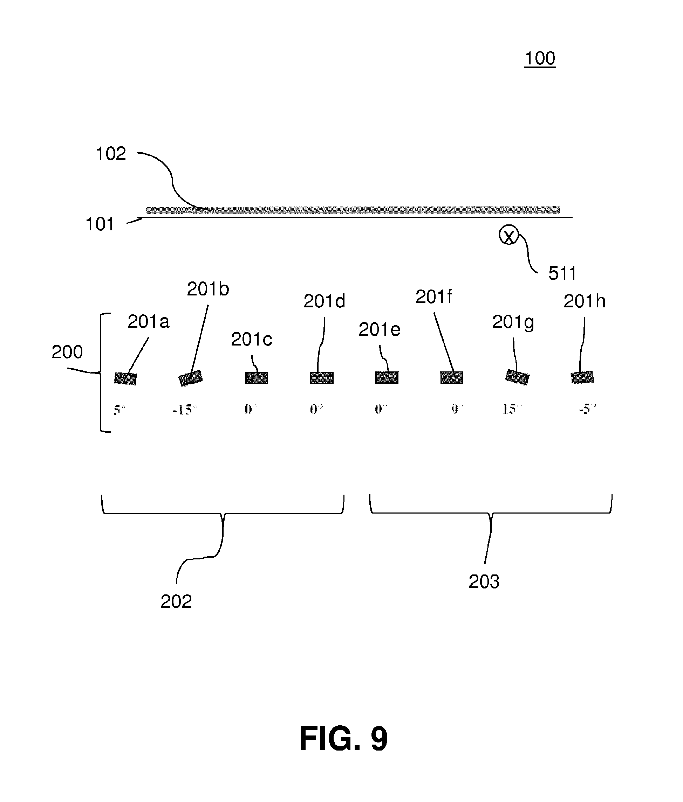

Fig. 8 and Fig. 9 relate to yet another typical embodiment. For comparison, the first film thickness profile 505 is indicated in the thickness distribution graph 500 shown in Fig. 8. Furthermore, the diagram in Fig. 8 includes a fifth film thickness profile 509 and a sixth film thickness profile 510 which have been obtained in an arrangement illustrated in Fig. 9. The first film thickness profile 505 indicated in Figs. 6 and 8 represents a lowest film thickness inhomogenity, whereas the film thickness profiles 506, 507 (Fig. 6) and 508, 509, 510 (Fig. 8) represent a larger film thickness inhomogeneity. The fourth film thickness profile 508 shown in Fig. 8 has been obtained by tilting the evaporator crucibles 201b and 201g, respectively, towards the edge of the substrate 101, as summarized in table 1 indicated herein below.

Table 1: Tilt angles 303 (in degrees; °) of the individual evaporator crucibles 201a-201h for obtaining the film thickness profiles 505-510 shown in the graphs of Fig. 6 and Fig. 8; a positive tilt angle 303 is defined as a tilt angle providing a tilt of the evaporator crucible 201 in a clockwise direction in the drawings, i.e. in a direction shown in Fig. 2, whereas a counter-clockwise tilt in the drawings is indicated by a negative tilt angle 303.

| Film thickness profile | 201a | 201b | 201c | 201d | 201e | 201f | 201g | 201h |
|---|---|---|---|---|---|---|---|---|
| 505 | +3 | -14 | -2 | -2 | +2 | +2 | +14 | -3 |
| 506 | +5 | 0 | 0 | 0 | 0 | 0 | 0 | -5 |
| 507 | +10 | 0 | 0 | 0 | 0 | 0 | 0 | -10 |
| 508 | 0 | -15 | 0 | 0 | 0 | 0 | +15 | 0 |
| 509 | +5 | -15 | 0 | 0 | 0 | 0 | +15 | -5 |
| 510 | 10 | -15 | 0 | 0 | 0 | 0 | +15 | -10 |

The fifth film thickness profile 509 shown in Fig. 8 has been obtained by tilting the outermost evaporator crucibles 201a and 201h, respectively, towards the center of the substrate by an angle of 5°, whereas the evaporator crucibles 201b and 201g, respectively, have been tilted towards the edge of the substrate, as in the situation which has been provided for obtaining the fourth film thickness profile 508.

The sixth film thickness profile 510 has been obtained by an additional tilt of the outermost evaporator crucibles 201a and 201h, respectively, towards the center of the substrate 101. The respective tilt angles or the film thickness profiles 505-510 are summarized in table 1 herein above. It is noted again that a positive tilt angle represents a tilt in the clockwise direction, wherein a negative tilt angle represents a tilt in the counter-clockwise direction, with respect to the arrangement shown in Fig. 7 and Fig. 9.

The arrangements shown in Fig. 7 and Fig. 9 are provided such that the evaporator crucibles 201 are located symmetrically with respect to the center of the substrate 101. According to a typical embodiment which can be combined with other embodiments described herein, at least two evaporator crucibles 201 may be adapted for directing the evaporator deposition material towards the substrate 101 in respective main emission directions 301.

The respective main emission directions 301 may be different from each other. In particular, the main emission direction 301 of a tilted evaporator crucible 201a-201h may be different from a direction normal to the substrate 101, i.e. the surface normal 302 (see Fig. 2). The deposition system 100 may further include the tiltable or tilted support unit 204 for each of a plurality of evaporator crucibles 201a-201h, wherein the tiltable or tilted support unit 204 is adapted for individually adjusting the main emission direction 301 of a respective evaporator crucible 201a-201h.

Thus, deposition material is evaporated from the plurality of evaporator crucibles 201a-201h in different main emission directions 301, i.e. the emission directions 301 of the individual evaporator crucibles 201 may be different from each other. According to a typical embodiment, it is thus possible to optimize the individual tilt angle 303 of the evaporator crucibles 201a-201h such that a layer thickness inhomogenity is decreased.

In particular, if the substrate 101 is transported in the substrate transport direction 511, deposition material may be evaporated from at least two evaporator crucibles 201 which are arranged symmetrically to a plane defined by the transport direction 511 and the surface normal 302. The individual evaporator crucible 201 is continuously variable, e.g. the evaporator crucible 201 is adapted to be tilted continuously.

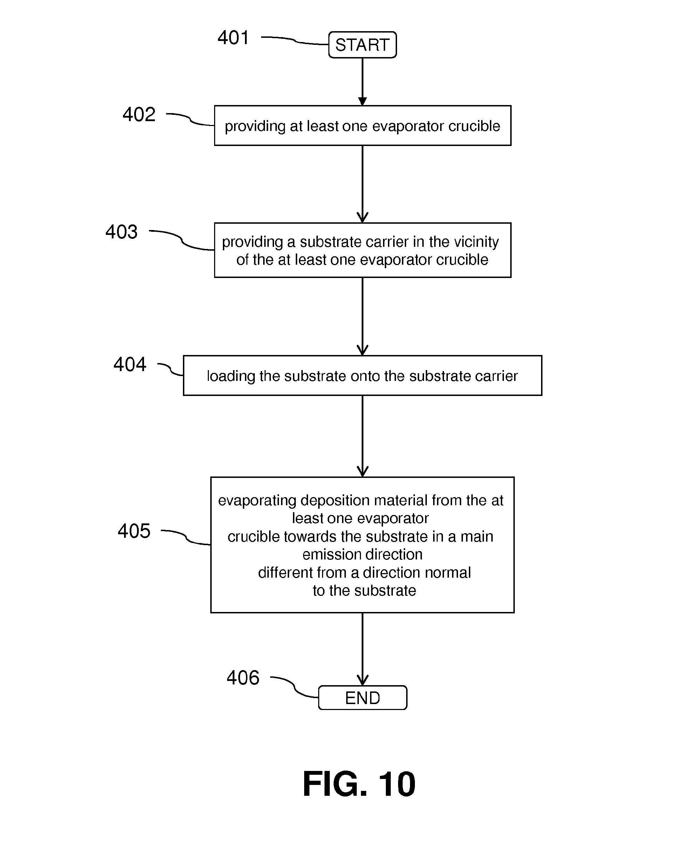

Fig. 10 is a flowchart illustrating a method for depositing a thin film onto a substrate. The procedure starts at a block 401. Then, at least one evaporator crucible is provided at a block 402. A substrate carrier is provided in the vicinity of the at least one evaporator crucible at a block 403. According to a typical embodiment, a distance between the substrate carrier 102 and the evaporation device 200 is in a range from 50 mm to 450 mm, and typically amounts to approximately 200 mm.

A substrate 101 is loaded onto the substrate carrier at a block 404. At a block 405, a deposition material is evaporated from the at least one evaporator crucible 201 towards the substrate 101 in a main emission direction 301 different from a direction normal 302 to the substrate 101. The procedure is ended at a block 406.

In light of the above, a plurality of embodiments have been described. For example, according to one embodiment, a deposition system adapted for depositing a thin film onto a substrate is provided, the deposition system including a substrate carrier adapted for carrying the substrate; and at least one tilted evaporator crucible adapted for directing evaporated deposition material towards the substrate in a main emission direction, wherein the main emission direction of the tilted evaporator crucible is different from a direction normal to the substrate. According to a further embodiment at least two evaporator crucibles are provided which are adapted for directing the evaporated deposition material towards the substrate in respective main emission directions, wherein the respective main emission directions are different from each other. According to at least one further embodiment which can be combined with other embodiments described herein, at least two evaporator crucibles are arranged symmetrically to a plane which is perpendicular to the substrate. According to an optional modification thereof, a plurality of evaporator crucibles arranged at a pitch in a range from 50 mm to 400 mm, and typically at a pitch of approximately 80 mm with respect to one another are provided. Furthermore, a plurality of evaporator crucibles are arranged in a line perpendicular to a transport direction of the substrate. According to yet further embodiments, which can be combined with any of the other embodiments and modifications above the evaporator crucible is tilted such that the main emission direction and the normal of the substrate form an angle in a range from -60 degrees to +60 degrees, typically in a range from -45° to +45°, more typically in a range from -25° to +25°, even more typically in a range from -15° to +15°, and even more typically in a range from -5 degrees to +5 degrees. According to yet another optional modification thereof the evaporator crucible is adapted to be tilted continuously. According to yet further additional or alternative modifications at least one evaporation crucible is adapted for providing a vapor cone having a cosine exponent in a range from 1 to 5. Moreover, the deposition system may include a tiltable or tilted support unit for each of the plurality of evaporator crucibles, the tiltable or tilted support unit being adapted for individually adjusting the main emission direction of a respective evaporator crucible. In addition to that, or alternatively, an even number of evaporator crucibles symmetrically arranged with respect to a plane defined by the transport direction and the normal of the substrate are provided. According to another embodiment, a method of depositing a thin film onto a substrate is provided including providing at least one evaporator crucible, providing a substrate carrier in the vicinity of the at least one evaporator crucible, loading the substrate onto the substrate carrier, and evaporating deposition material from the at least one evaporator crucible towards the substrate in a main emission direction different from a direction normal to the substrate. According to an optional modification thereof, at least two evaporator crucibles are provided and wherein the main emission directions of the evaporated deposition material of the at least two evaporator crucibles are different from each other. According to yet further embodiments, which can be combined with any of the other embodiments and modifications above, the main emission direction may be tilted by an angle in a range from -60 degrees to +60 degrees, typically in a range from range from -15 degrees to +15 degrees, and more typically in a range from -5 degrees to +5 degrees, with respect to a normal of the substrate. Furthermore, the substrate is transported in a transport direction, and wherein deposition material is evaporated from at least two evaporator crucibles arranged symmetrically to a plane defined by the transport direction and the normal of the substrate. According to yet another embodiment evaporating deposition material from the at least one evaporator crucible may include spatially varying a vapour cone of the at least one evaporator crucible.

While the foregoing is directed to embodiments of the invention, other and further embodiments of the invention may be devised without departing from the basic scope thereof, and the scope thereof is determined by the claims that follow.

## Claims

1. A deposition system adapted for depositing a thin film onto a substrate, the deposition system comprising:
a substrate carrier adapted for carrying the substrate; and
at least one tilted evaporator crucible adapted for directing evaporated deposition material towards the substrate in a main emission direction, wherein
the main emission direction of the tilted evaporator crucible is different from a direction normal to the substrate.

2. The deposition system in accordance with claim 1, comprising at least two evaporator crucibles adapted for directing the evaporated deposition material towards the substrate in respective main emission directions, wherein the respective main emission directions are different from each other.

3. The deposition system in accordance with claim 1 or 2, wherein at least two evaporator crucibles are arranged symmetrically to a plane which is perpendicular to the substrate.

4. The deposition system in accordance with any one of the preceding claims, wherein a plurality of evaporator crucibles arranged at a pitch in a range from 20 mm to 100 mm, and typically at a pitch of approximately 80 mm with respect to one another are provided.

5. The deposition system in accordance with any one of the preceding claims, wherein a plurality of evaporator crucibles are arranged in a line perpendicular to a transport direction of the substrate.

6. The deposition system in accordance with any one of the preceding claims, wherein the evaporator crucible is tilted such that the main emission direction and the normal of the substrate form an angle in a range from -60 degrees to +60 degrees, typically in a range from range from -25 degrees to +25 degrees, and more typically in a range from -5 degrees to +5 degrees.

7. The deposition system in accordance with any one of the preceding claims, wherein the evaporator crucible is adapted to be tilted continuously.

8. The deposition system in accordance with any one of the preceding claims, wherein the at least one evaporation crucible is adapted for providing a vapor cone having a cosine exponent in a range from 1 to 5, typically in a range from 3 to 4, and more typically of approximately 3.5.

9. The deposition system in accordance with any one of the preceding claims, further comprising a tiltable support unit for each of the plurality of evaporator crucibles, the tiltable support unit being adapted for individually adjusting the main emission direction of a respective evaporator crucible.

10. The deposition system in accordance with any one of the preceding claims, wherein an even number of evaporator crucibles symmetrically arranged with respect to a plane defined by the transport direction and the normal of the substrate are provided.

11. A method for depositing a thin film onto a substrate, the method comprising:
providing at least one evaporator crucible;
providing a substrate carrier in the vicinity of the at least one evaporator crucible;
loading the substrate onto the substrate carrier; and
evaporating deposition material from the at least one evaporator crucible towards the substrate in a main emission direction different from a direction normal to the substrate.

12. The method in accordance with claim 11, wherein at least two evaporator crucibles are provided and wherein the main emission directions of the evaporated deposition material of the at least two evaporator crucibles are different from each other.

13. The method in accordance with claim 11 or 12, wherein the main emission direction is tilted by an angle in a range from -45 degrees to +45 degrees, typically in a range from range from -15 degrees to +15 degrees, and more typically in a range from -5 degrees to +5 degrees, with respect to a normal of the substrate.

14. The method in accordance with any one of the claims 11 to 13, wherein the substrate is transported in a transport direction, and wherein deposition material is evaporated from at least two evaporator crucibles arranged symmetrically to a plane defined by the transport direction and the normal of the substrate.

15. The method in accordance with any one of the claims 11 to 14, wherein evaporating deposition material from the at least one evaporator crucible comprises spatially varying a vapour cone of the at least one evaporator crucible.
